# EUROPEAN PATENT SPECIFICATION

(11) **EP 2 203 784 B1**
(45) Date of publication and mention of the grant of the patent: **10.08.2011**
(21) Application number: 08840508.9
(22) Date of filing: 17.10.2008
(51) Int. Cl.: G03F 7/20

(54) **DISPLACEMENT DEVICE WITH PRECISION POSITION MEASUREMENT**
VERSCHIEBUNGSVORRICHTUNG MIT PRÄZISIONSPOSITIONSMESSUNG
DISPOSITIF DE DÉPLACEMENT AVEC MESURE DE PRÉCISION

(30) Priority: 19.10.2007 US 981118 P
(43) Date of publication of application: 07.07.2010
(73) Proprietor: Koninklijke Philips Electronics N.V., 5621 BA Eindhoven (NL)
(72) Inventor: FRISSEN, Petrus, C., M., NL-5656 AE Eindhoven (NL); KLAVER, Renatus, G., NL-5656 AE Eindhoven (NL)
(74) Representative: Kroeze, Johannes Antonius
(86) International application number: PCT/IB2008/054269
(87) International publication number: WO 2009/050675

(56) References cited:
- EP-A- 0 834 773
- EP-A- 1 808 883
- EP-A1- 1 993 121
- EP-A1- 1 993 121
- WO-A-2006/054255
- WO-A-2006/054258
- WO-A-2006/075291
- US-A1- 2001 010 579
- US-A1- 2009 059 194

## Description

This invention relates generally to displacement devices, and more specifically to displacement devices with precision measurement.

Increased precision in manufactured components requires increased precision in measurement. Precision is required in the manufacture, inspection, and repair of precision components, such as semiconductor integrated circuits. For example, displacement devices move semiconductor wafers to expose the surface of the semiconductor wafers to beams of various wavelengths for various purposes. Optical or ultraviolet (UV) beams can be used for photolithography, optical or electron beams can be used for inspection, and ion beams can be used for repair. The motion of the semiconductor wafer must be precise to locate the beam at the minute features being created or already created on the wafer. Precise motion requires precise measurement.

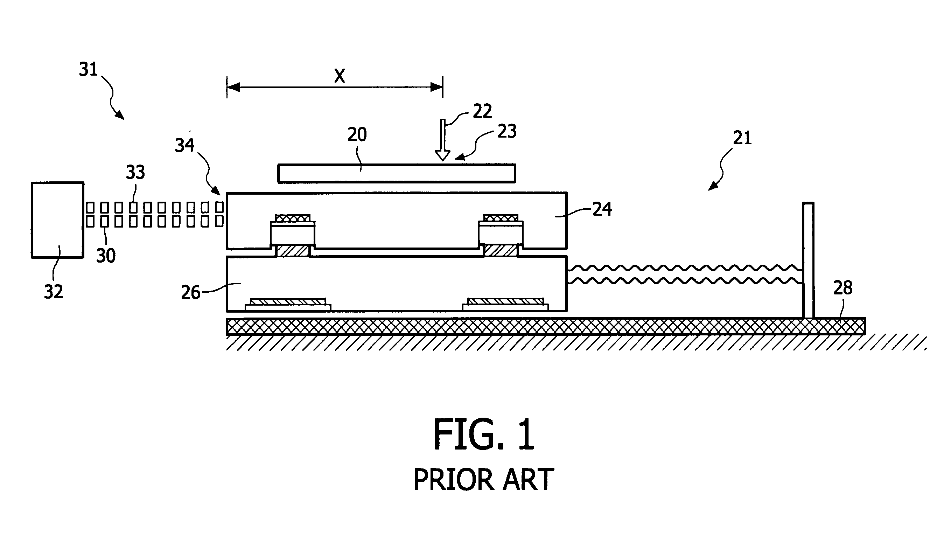

**FIG. 1** is a schematic side view of a displacement device made in accordance with the prior art. A short stroke carrier **24** of displacement device **21** supports a wafer **20** that is exposed to a work beam **22.** A long stroke carrier **26** supports the short stroke carrier **24** relative to magnet plate **28.** Interferometry system **31** measures the position of the short stroke carrier **24.** Interferometer control unit **32** directs a light beam **30** onto the measuring point **34** of the vertical side of the short stroke carrier **24.** The interferometer control unit **32** compares a reflected beam **33** to a reference beam to determine the distance between the interferometer control unit **32** and the measuring point **34.** This distance is then used to determine the position of the working point **23** where the work beam **22** should hit the wafer **20.**

Unfortunately, the present measurement system has a number of limitations. The distance X between the measuring point **34** and the working point **23** is large, such as 400 millimeters for photolithographic applications, compounding any uncertainties in measurement. Typically, precision of 1 nanometer in the plane of the wafer **20** and 7 nanometer out of the plane of the wafer **20** is required. Small changes in temperature of the short stroke carrier **24** caused by beam exposure, internal magnetic coils, and internal cooling, result in significant changes to the distance X and loss of precision. One approach to minimize this effect has been to make the short stroke carrier **24** from materials with small thermal expansion coefficients, such as Zerodur^{®} glass ceramic material. This is not a satisfactory solution, however, because the material is expensive and heavy.

EP1 993 121 A1, published after the priority date of the present application, discloses an exposure apparatus and a device manufacturing method.

It would be desirable to have a displacement device with precision measurement that overcomes the above disadvantages.

One aspect of the present invention provides a displacement device for supporting a workpiece including an optical sensor; a support plate; and a planar motor disposed parallel the support plate, the planar motor having a first side operable to support the workpiece and a second side opposite the support plate; characterized in that the support plate defines a support plate aperture and a 2D-grating is disposed on the planar motor, the 2D-grating being in optical communication with the optical sensor through the support plate aperture.

Another aspect of the present invention provides a displacement device for supporting a workpiece including a plurality of optical sensors; a support plate defining a plurality of support plate apertures; a planar motor disposed parallel the support plate, the planar motor having a first side operable to support the workpiece and a second side opposite the support plate; and a 2D-grating disposed on the planar motor, the 2D-grating being in optical communication with the plurality of optical sensors through the plurality of support plate apertures. The number of the plurality of optical sensors is at least a determinative measurement number.

The foregoing and other features and advantages of the invention will become further apparent from the following detailed description of the presently preferred embodiment, read in conjunction with the accompanying drawings. The detailed description and drawings are merely illustrative of the invention rather than limiting, the scope of the invention being defined by the appended claims and equivalents thereof.
**FIG. 1** is a schematic diagram of a displacement device made in accordance with the prior art;
**FIG. 2** is a schematic diagram of a displacement device made in accordance with the present invention;
**FIGS. 3-6** are schematic diagrams of a support plate and planar motor for a displacement device made in accordance with the present invention;
**FIGS. 7-9** are schematic diagrams of an optical sensor and 2D-grating for a displacement device made in accordance with the present invention;
**FIGS. 10A-10B** are schematic diagrams of additional embodiments of a displacement device made in accordance with the present invention;
**FIG. 11** is a schematic diagram of another embodiment of a displacement device made in accordance with the present invention; and
**FIGS. 12A-12B** are schematic diagrams of yet another embodiment of a displacement device made in accordance with the present invention.

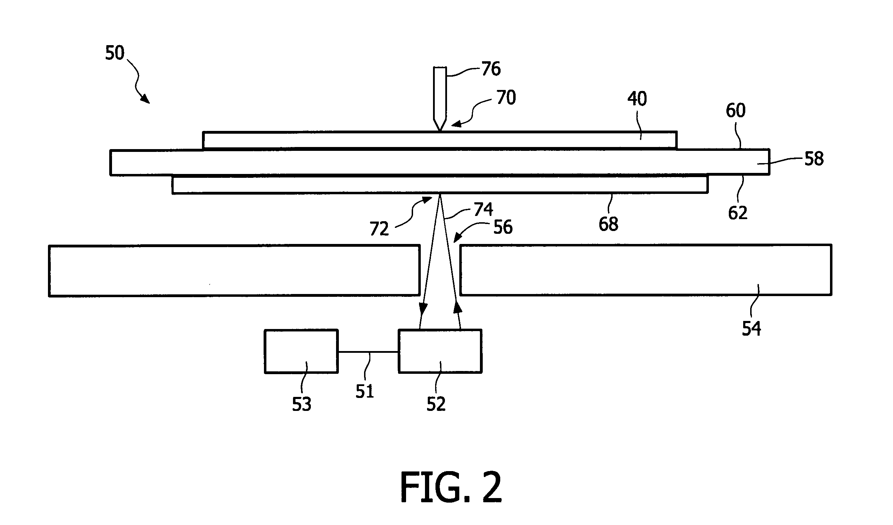

**FIG. 2** is a schematic diagram of a displacement device made in accordance with the present invention. The displacement device **50** can support a workpiece **40** and includes an optical sensor **52;** a support plate **54** defining a support plate aperture **56;** a planar motor **58** disposed parallel the support plate **54,** the planar motor **58** having a first side **60** operable to support the workpiece **40** and a second side **62** opposite the support plate **54;** and a 2D-grating **68** disposed on the planar motor **58,** the 2D-grating **68** being in optical communication with the optical sensor **52** through the support plate aperture **56.** The support plate **54** electromagnetically supports and moves the planar motor **58,** which supports the workpiece **40.** The optical sensor **52** can provide a position information signal **51** to a processor **53.** When a number of optical sensors **52** are used, the processor **53** can receive a number of position information signals **51** from the number of optical sensors **52.**

In this example, the optical sensor **52** is located across the planar motor **58** from a working point **70** on the workpiece **40,** with the planar motor **58** including magnets and the support plate **54** including coils. The working point **70** can be a sharp point as illustrated or a broad plane over the surface of the workpiece **40.** The measuring point **72** where the sensing beam **74** from the optical sensor **52** strikes the 2D-grating **68** is near the working point **70** where the working beam **76** strikes the workpiece **40,** so that the position of the working point **70** can be precisely determined. The planar motor **58** is typically in the range of 2 to 5 millimeters thick. In this example, the optical sensor **52** is a six-degree-of freedom optical sensor, i.e., an optical sensor measuring three degrees of translation and three degrees of rotation, and the 2D-grating **68** is disposed on the second side **62** of the planar motor **58.** A measurement repeatability of 0.1 nanometer for translation and 1 microrad for rotation can be achieved using a six-degree-of-freedom optical sensor. Those skilled in the art will appreciate that the accuracy is also dependent on the quality of the 2D-grating. In one embodiment, the 2D-grating **68** is a transparent body, such as a body made of polycarbonate, with the grating pattern printed on the side of the 2D-grating **68** adjacent to the second side **62** of the planar motor **58.** Such grating patterns can be printed using holography, interferometry, lithography, or the like. In another embodiment when more than one optical sensor is used, the 2D-grating **68** can be one large grating or a number of separate gratings disposed at particular points about the planar motor **58** to receive the sensing beams **74** from the optical sensors **52.**

The workpiece **40** can be any workpiece that needs to be moved and precisely positioned. The working beam **76** is applied to the workpiece **40** at the working point **70** to achieve the desired effect on the workpiece **40.** Examples of working beams include visible light beams, ultraviolet (UV) beams, extreme ultraviolet beams, electron beams (e-beams), ion beams, or the like. Visible light beams, ultraviolet (UV) beams, extreme ultraviolet beams, electron beams (e-beams) can be used for photolithography or inspection, and ion beams can be used for repair. Typically, the workpiece **40** is a thin planar object, such as a wafer. In one example, the workpiece is a semiconductor wafer. In another example, the workpiece is a printed circuit board. Those skilled in the art will appreciate that the working beam **76** need not contact the workpiece **40** at a sharp point as illustrated in **FIG. 2****.** The working beam **76** can spread over all or part of the workpiece **40** so that the working point **70** is not a sharp point, but a broad plane over the surface of the workpiece **40.** For example, the workpiece **40** can be a die with dimensions of 26 x 32 millimeters and the working beam **76** can spread over the full 26 x 32 millimeters.

The 2D-grating **68** can be a grating with a structure that is periodic in two directions which do not coincide. One example of such a structure is a checkerboard pattern. The 2D-grating **68** is shown as having substantial thickness for clarity of illustration, although the thickness can be minimal. The 2D-grating **68** can be an integral component, such as a transparent sheet with a grating pattern printed on the transparent sheet, affixed to the planar motor **58,** or can be part of the planar motor **58** itself. In another embodiment, one or more Z-gratings can be disposed adjacent the 2D-grating **68** to form a 3D-grating.

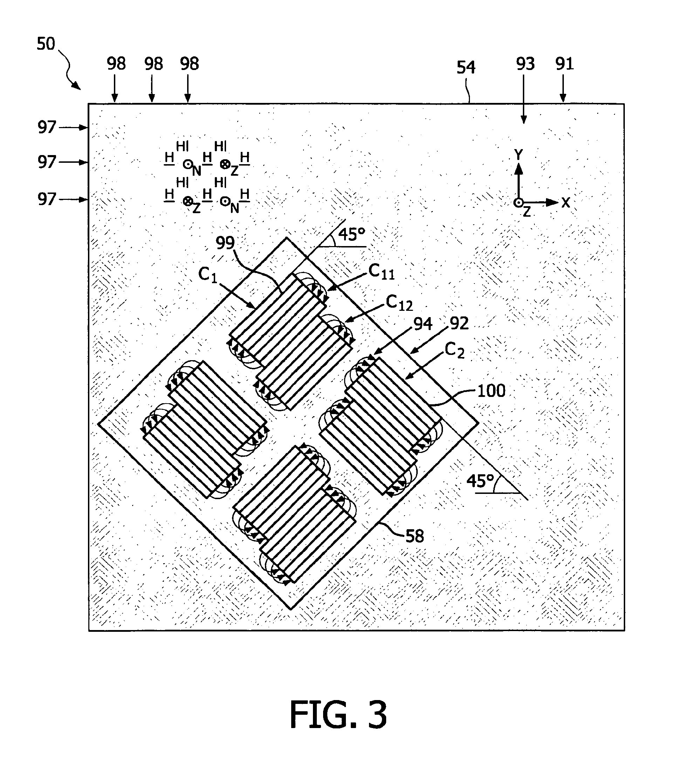

**FIGS. 3-6****,** in which like elements share like reference numbers with **FIG. 2** and each other, are schematic diagrams of a support plate and planar motor for a displacement device made in accordance with the present invention. The support plate aperture through the support plate **54** and 2D-grating on the planar motor **58** have been omitted for clarity of illustration. The support plate **54** electromagnetically floats the planar motor **58** supporting a workpiece, as described in WIPO International Publication WO 2006/075291 A2.

Referring to **FIG. 3****,** the displacement device **50** includes a first part **91** formed by a system **93** of magnets, and a second part **92** formed by an electric coil system **94.** The magnets are secured onto the planar motor **58** and the coil system is secured onto the support plate **54.** The first and the second parts **91, 92** can move with respect to each other. In this example, the stationary part is the support plate **54** with the magnets, and the movable part is the planar motor **58** with the coils.

The magnets of the magnet system **93** are arranged in a pattern of rows **97** extending parallel to the X-direction, and columns **98** extending parallel to the Y-direction, the interspace between the rows and between the columns being the same. In each row **97** and in each column **98,** magnets of a first type N and of a second type Z are alternately arranged. The magnets of the first type N have a direction of magnetization which extends at right angles to the planar motor **58** and towards the second part **92** with the electric coil system **94,** while the magnets of the second type Z have a direction of magnetization which extends at right angles to the planar motor **58** and away from the second part **92** with the electric coil system **94.** In each row **97** and in each column **98,** a magnet of a third type H is arranged between each pair of magnets of the first type N and the second type Z. The direction of magnetization of the magnets of the third type H which are situated between the columns **98,** extends parallel to the Y-direction and towards the adjacent magnet of the first type N, while the direction of magnetization of the magnets of the third type H which are situated between the rows 97, extends parallel to the X-direction and also towards the adjacent magnet of the first type N. Arrows indicate the directions of magnetization of the different types of magnets N, Z, and H.

The electric coil system **94** is provided with at least one coil of a first type C₁ whose current conductors **99,** which are situated in the effective magnetic field of the magnets, include an angle of 45° with the X-direction, and the electric coil system **94** is also provided with at least one coil of a second type C₂ having current conductors **100,** which are also situated in the effective magnetic field of the magnets, include an angle of 45° with the X-direction, and extend perpendicularly to the current conductors **99** of the coil of the first type C₁. As used herein, "current conductors in the effective magnetic field" means that part of the coil, generally a bunch of current conductors, is situated in the magnetic field of the magnets, and that an effective Lorentz force is exerted on the part of the coil, causing a movement of the coil.

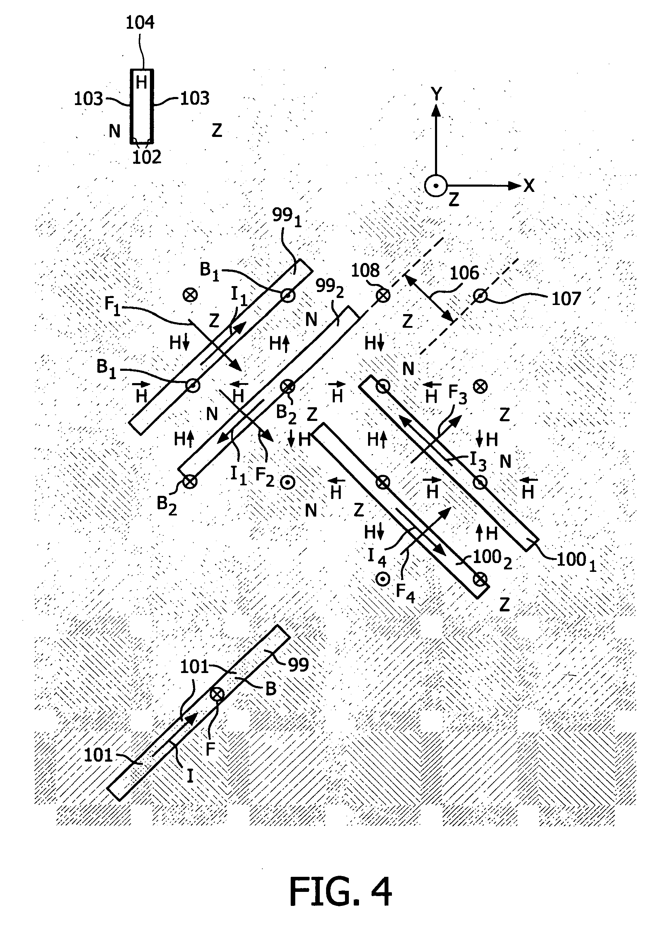

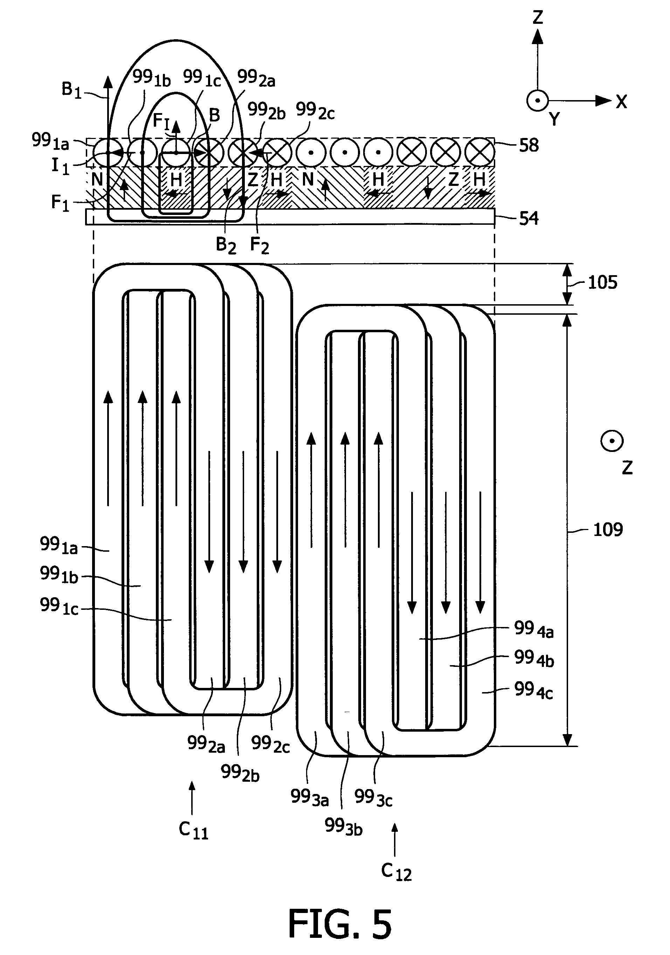

Referring to **FIG. 4** to explain the manner in which the coils move in the system of magnets, the reference numerals **99₁, 99₂** and **100₁, 100₂** represent current conductors of the coils C₁ and C₂, respectively, which are provided in the magnetic fields of the magnets. Current conductor **99₁** is situated predominantly in the magnetic fields of the magnets indicated by the letter N. The direction of magnetization of these N magnets is indicated by an arrow pointing upwards, i.e., directed at right angles to the system of magnets and towards the current conductor **99₁.** The arrow B1 indicates the direction of the magnetic field. When an electric current flows through the current conductor **99₁** in the direction indicated by the arrow I₁, a force F₁ is exerted on the current conductor in the direction indicated by the relevant arrow, as a result of which the current conductor wants to start moving in the direction of the arrow F₁. Current conductor **99₂** is predominantly situated in the magnetic fields of the magnets referenced Z. The direction of magnetization of the Z magnets is indicated by an arrow B₂ which points downwards, i.e., at right angles to the system of magnets and away from the current conductor **99₂.** When an electric current flows through the current conductor **99₂** in accordance with the arrow I₂, i.e., counter to the current I₁, a force F₂ in the direction indicated by the relevant arrow is exerted on the current conductor **99₂,** as a result of which the current conductor wants to start moving in the direction indicated by the arrow F₂, i.e., in the same direction as the arrow F₁. In the same manner, the current conductors **100₁** and **100₂,** which are arranged at right angles to the current conductors **99₁** and **99₂,** are subject to a force extending in the direction indicated by the arrows F₃ and F₄, under the influence of the magnetic fields of the N and Z magnets at a current in accordance with the arrows I₃ and I₄. When the currents in the current conductors are reversed, the force exerted on the current conductors, and hence the movement of the current conductors, is also reversed. This interplay of forces is also shown In **FIG. 5****.**

Referring to **FIG. 3****,** parts **101** of current conductors **99, 100** are also present above the magnets of the third type H and/or above parts where there is no magnet, i.e., between the magnets of the first type N and the second type Z. These parts of the current conductors are situated in a magnetic field B whose average direction extends substantially parallel to the X-Y plane. See also current conductor **99_{1c}** in **FIG. 4****.** Referring to **FIG. 3****,** when a current I runs through this current conductor, the parts **101** of the current conductor is be subject to a force F in a direction perpendicular to the X-Y plane, i.e., the Z-direction. Depending on the direction of the current and the position of the current conductor with respect to the magnets, the force is directed towards the magnets or away from the magnets. When the force is directed away from the magnets, the force is referred to as the levitation force F₁, i.e., a force causing the current conductor to move away from the magnets. Such a force can be used to provide a bearing function between the support plate and the magnets.

The magnets of the first type N and the second type Z are square in shape. The magnets of the third type H are rectangular and dimensioned so that the longest side faces **102** of an H magnet border on the side faces **103** of an N magnet and a Z magnet, and the ratio between the dimension of the shortest side face **104** and the dimension of the longest side face **102** of a H magnet can lie in the range between 0.25 and 0.50 to provide the greatest strength of the magnetic field per unit area of the magnet system according to optimization analysis.

**FIG. 5** illustrates two sets of three coils, i.e., a first set C₁₁ with current conductors **99₁ₐ, 99_{1b}, 99_{1c}** and return current conductors **99₂ₐ, 99_{2b}, 99_{2c},** and a second set C₂₁ with current conductors **99₃ₐ, 99_{3b}, 99_{3c}** and return current conductors **99₄ₐ, 99_{4b}, 99_{4c}.** Both sets of coils are fed by a three-phase current system. Viewed in the longitudinal direction of the current conductors, the first set C₁₁ of three current conductors is shifted over a distance **105,** which is approximately half the pole pitch **106** of the magnets, with respect to the second set C₂₁ of three current conductors. The pole pitch **106** of the magnets as used herein is the distance between two adjacent diagonal lines on which the center points **107** and **108** of magnets of the same type, respectively, N and Z are situated. This avoids a variable torque being exerted on both sets of current-carrying coils during displacement, which causes an oscillating movement of the moving part (support plate or planar motor with magnets) around the Z-axis with respect to the stationary part. By shifting the sets of coils with respect to each other, this oscillating effect is substantially reduced because a torque develops in one of the two sets of coils which compensates for the torque in the other set. The oscillating effect could induce vibrations in the support plate **54** when the support plate **54** is the movable part.

The length **109** of the current conductors is selected to be approximately equal to k times the pole pitch **106** of the magnets, with k being a multiple of 2. As a result, the sum of the magnetic field remains approximately constant upon a movement of the current conductor in the longitudinal direction, causing fluctuations in the force exerted on the current conductor to be smaller. This is not dependent on the number of coils and phases.

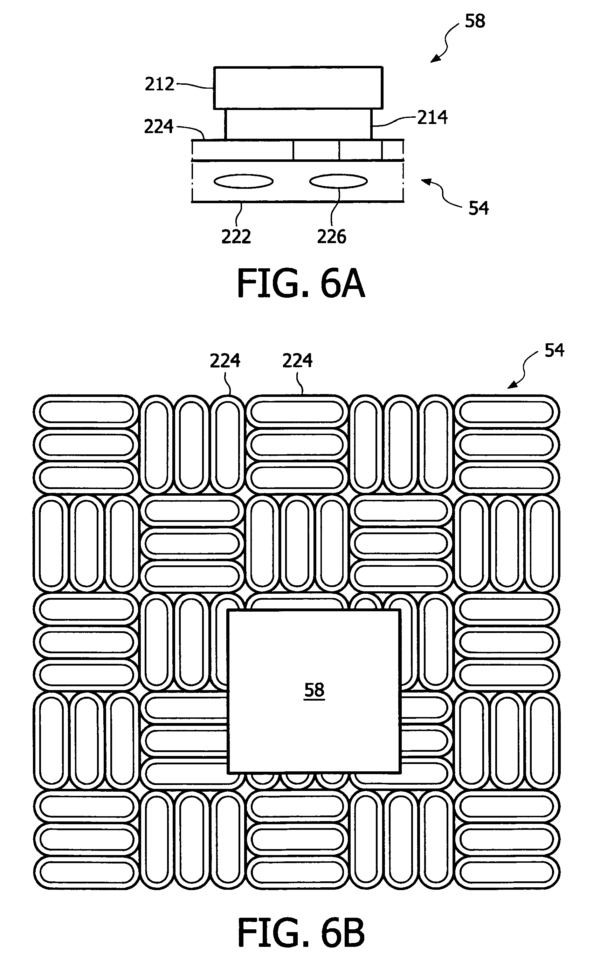

**FIGS. 6A & 6B** illustrate a cross-section and top view, respectively, of a displacement device with a first part or planar motor **58** and a second part or stationary support plate **54.** In this example, the planar motor **58** includes a carrier **214** with a mirror block **212** on top of the carrier **214.** The planar motor **58** can move with respect to the stationary support plate **54.** Coils **224** are arranged on a coil block **222** that is fluid-cooled via cooling channels **226.** The coils **224** are arranged in groups of three with the orientation of neighboring groups being offset by 90 degrees. Those skilled in the art will appreciate that other coil arrangements, such as groups of more or less than three coils, are possible as desired for a particular application. Those skilled in the art will further appreciate that in one embodiment, the coils are in the support plate **54** and the magnets are in the planar motor **58,** while in another embodiment, the magnets are in the support plate **54** and the coils are in the planar motor **58.**

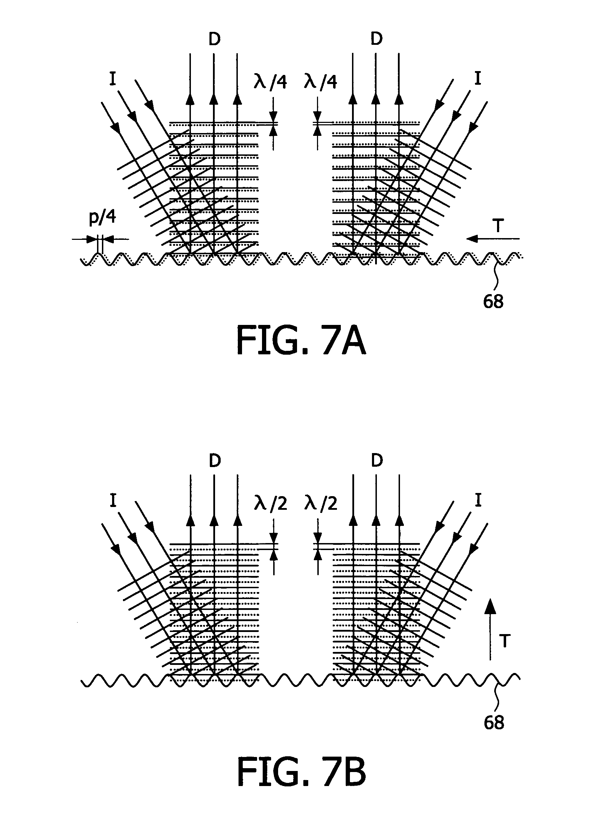

**FIGS. 7-9****,** in which like elements share like reference numbers, are schematic diagrams of an optical sensor and 2D-grating for a displacement device made in accordance with the present invention. The support plate with support plate aperture between the optical sensor **52** and the 2D-grating **68** has been omitted for clarity of illustration. The optical sensor **52** detects translation and rotation of the 2D-grating **68** attached to the planar motor supporting a workpiece. The optical sensor **52** is described in WIPO International Publication WO 2006/054258 A2. Those skilled in the art will appreciate that the optical sensor **52** discussed below is a six-degree-of-freedom optical sensor operable to measure three degrees of translation and three degrees of rotation. The six-degree-of-freedom optical sensor can be converted to a three-degree-of-freedom optical sensor operable to measure three degrees of translation by omitting the position sensitive detectors. Those skilled in the art will appreciate that more than one three-degree-of-freedom optical sensor is required to measure the position of the 2D-grating **68** attached to the planar motor supporting a workpiece.

**FIGS. 7A & 7B** illustrate incident and diffracted light beams for the optical sensor **52.** Two incident light beams **I** are provided at the 2D-grating **68** from different directions. The phase of each diffracted beam D is measured individually by measuring interference between an incident beam I and a diffracted beam D. Accordingly, a phase shift of λ/4 is measured for each pair of incident and diffracted beams for in-plane translation of pitch/4 (p/4) and a phase shift of λ/2 is measured for each pair for out-of-plane translations. To determine both the in-plane and out-of-plane translation, the system is arranged to distinguish phase shift contributions of the in-plane and out-of-plane translations. The in-plane translations can be determined optically or otherwise.

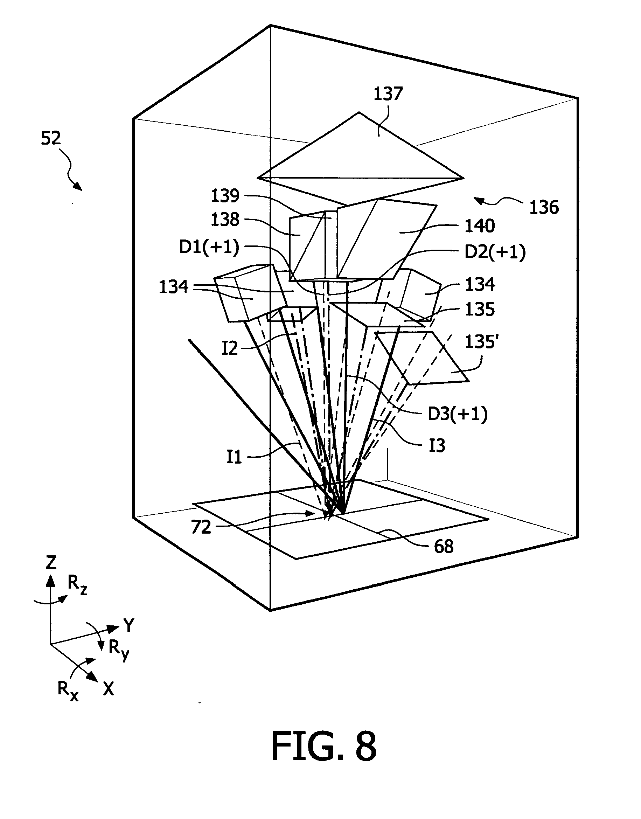

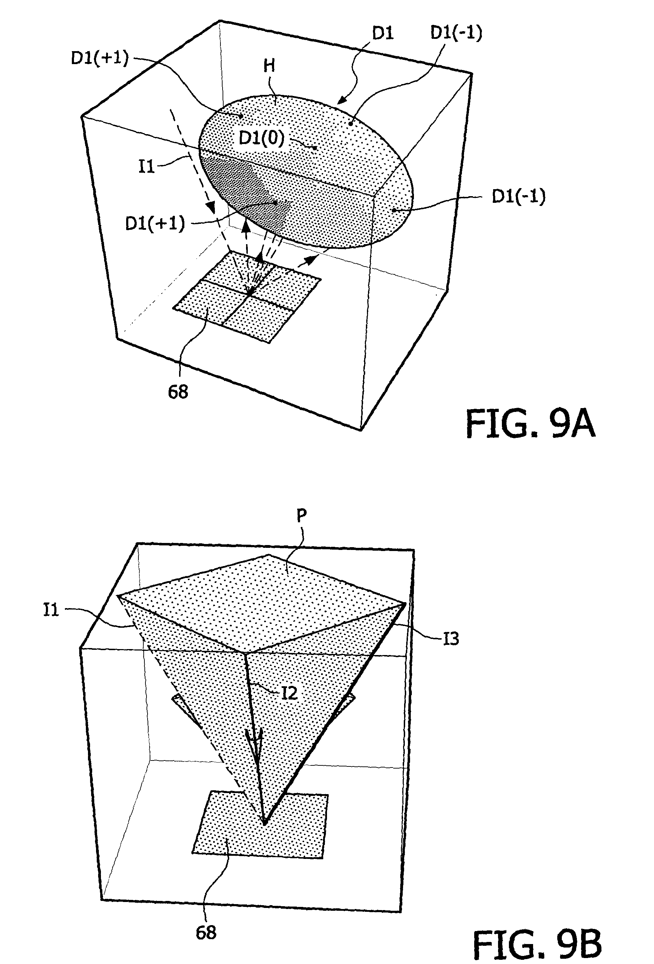

**FIGS. 8****,** **9A, & 9B** illustrate an exemplary optical sensor **52** for detecting translations T and rotation R of the planar motor (not shown) with a 2D-grating **68** applied to the planar motor. The optical sensor **52** includes optical heads **134** to provide first, second, and third incident light beams 11,12,13 from different directions to the 2D-grating **68.** First, second, and third diffracted light beams D1, D2, D3 result from the incident light beams I1, I2, I3, respectively. The diffraction orders -1, 0, and +1 are shown for the diffracted beams D1, D2, D3. Pairs of incident I and diffracted beams D are indicated in black, dark-gray, and light gray. For clarity of illustration, the beams as shown in **FIG. 8** do not coincide at the same measuring point **72,** but at three different spots with a small offset between them. The three beams actually coincide at the same measuring point **72.** The optical heads **134** further include means for measuring the phase difference ΔΦ between at least one of the pairs consisting of the first incident beam I1 and the first diffracted beam D1, the second incident beam I2 and the second diffracted beam D2, and the third incident beam 13 and the third diffracted beam D3. As long as the optical power of the diffraction orders is sufficient, every diffraction order of the diffracted beams D1, D2, D3 can be used for measuring the phase difference ΔΦ. The wavelengths and angles of incidence of the beams I1, I2, 13 and the period *p* of the 2D-grating **68** are selected such that the diffraction order +1 of the diffracted beams D1, D2, D3 are used for detecting the translation T of the 2D-grating **68** with the optical heads **134.**

The optical sensor **52** further includes position sensitive detectors **135, 135'** arranged to receive further orders of the diffracted light beams D1, D2, D3 to detect rotation R of the planar motor. A rotation Rx, Ry, Rz of the 2D-grating **68** results in a displacement of these orders on the position sensitive detectors **135, 135'** so that rotation of the planar motor can be detected. When the planar motor rotates, the phases of the diffracted beams D1, D2, D3 for measuring translation of the planar motor as the path length for one or more light beams may vary. Therefore, for a planar motor with a significant rotating motion component Rx, Ry, Rz, rotation should be determined to calculate the translation of the planar motor. The six-degree-of-freedom optical sensor can be converted to a three-degree-of-freedom optical sensor operable to measure three degrees of translation by omitting the position sensitive detectors.

More precisely, diffraction orders are indicated by two coordinates for a 2D-grating **68.** The first order is indicated by (0,0), the first order in the x-direction by (1,0), the first order in the y-direction by (0,1), *et cetera.* In this example, the further orders (0,0) and (-1,0) are used for measuring the rotation of the planar motor. The order (0,0), hereinafter indicated again by order 0, is only sensitive to the rotations Rx and Ry, while higher orders, here (-1,0), are sensitive to Rx, Ry, and Rz. However, other further orders, such as (-1,-1), may be used as well. Hereinafter, the indication of the order by two coordinates is omitted for clarity. The diffracted +lst order beams D1, D2, D3 are directed to zero-offset retroreflector **136.** After passing this retroreflector, the beams D1, D2, and D3 are directed to the 2D-grating **68** for a second time. Some of the diffracted beams are incident on the optical heads **134** and the phase of these further diffracted beams is measured to detect translation of the 2D-grating **68.**

The diffracted orders 0 and -1 fall onto the two-dimensional position sensitive detector 135 and a one-dimensional position sensitive device **135',** respectively. The position of the spot of diffraction order 0 is measured in two directions with the two-dimensional position sensitive detector **135,** whereas the position of the -1st order beam is measured in one direction with the one-dimensional position sensitive device **135'.** The three phase measurements and the three spot position measurements are used to determine the three translations and three rotations of the 2D-grating **68.** Exemplary position sensitive detectors are the NanoGrid Planar Encoder System available from OPTRA, Inc., of Topsfield, Massachusetts, USA, and the PP 281 R Two-Coordinate Incremental Encoder available from Dr. Johannes Heidenhain GmbH, Traunreut, Germany. Those skilled in the art will appreciate that the higher dimension position sensitive detector can be used to measure fewer dimensions of translation. For example, a three-dimensional position sensitive detector can be used to measure two or one dimensions, or a two-dimensional position sensitive detector can be used to measure one dimension.

**FIG. 9A** illustrates one of a single incident beam I1 with its associated diffraction beam D1 of the orders +1, 0, and -1. Only the single incident beam is shown and other incident beams are omitted for clarity. The grating period p, the wavelength X, and the-angle of incidence are selected such that the diffracted +1st order beam in the plane of incidence is directed along the normal η of the 2D-grating **68.** The virtual spherical surface H is illustrated to show the orientation of the diffraction orders more clearly. The cross-lines in the 2D-grating **68** show the orientation of the two-dimensional diffraction grating.

**FIG. 9B** illustrates the three incident light beams I1, I2, I3, with the three optical heads **134** positioned and oriented such that the three incident light beams I1, I2, I3 are directed along three edges of a virtual pyramid P. Referring to **FIG. 8****,** the diffracted +lst order beams D1(+1), D2(+1) and D3(+1) in the plane of incidence of the three incident beams are parallel to each other and directed to the zero-offset retroreflector **136.** This is typical for the beam layout in which the incident beams are directed along the edges of a virtual pyramid P. The function of the zero-offset retroreflector **136,** hereinafter also referred to as zero-offset retroreflector, is to redirect an incoming beam such that the reflected beam is parallel to the incoming beam and also coincides with the incoming beam. The zero-offset retroreflector **136** comprises a cube corner **137,** a polarizing beam splitter cube **138,** a half wavelength plate **139,** and a prism **140** acting as folding mirror. Normally, cube corners are used as retroreflectors. The incident and reflected beams are parallel to each other, but are spatially separated. The zero-offset retroreflector **136** redirects an incident beam along the same optical path back to the 2D-grating **68.** If the direction or the position of the incident beam is not nominal, then the offset between the incident and reflected beams will not be zero. The configuration of the optical heads **134** depends on the method with which the phase of the diffracted beams D1, D2, D3 is measured. The measurement configurations can include several optical components as known in the art, such as wavelength plates for modifying the polarization of the incident light beam, optical splitters, and Faraday components.

The 2D-grating **68** can be a grating with a structure that is periodic in two directions which do not coincide. In one embodiment, the 2D-grating **68** is a checkerboard pattern. In another embodiment, one or more Z-gratings (not shown) can be disposed adjacent the 2D-grating **68** to form a 3D-grating. A multi-layer grating, such as a 3D-grating, allows measurement over an increased range of rotation of the planar motor **58** and/or a combination of a relative and an absolute measurement. A multi-layer grating is described in WIPO International Publication WO 2006/054255 A1.

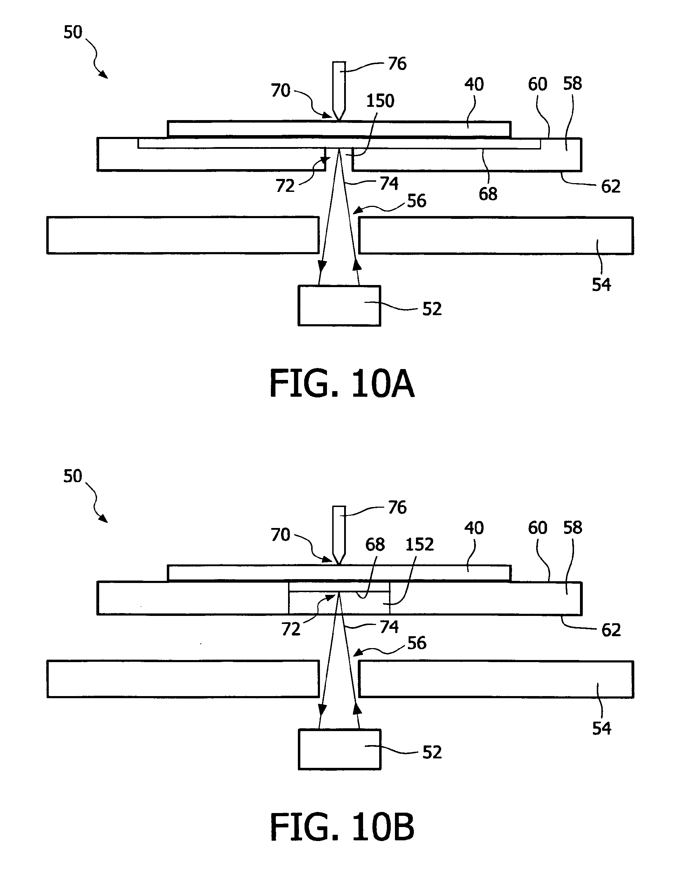

**FIGS. 10A-10B****,** in which like elements share like reference numbers with **FIG. 2** and with each other, are schematic diagrams of additional embodiments of a displacement device made in accordance with the present invention. The 2D-grating can be disposed at various locations on the planar motor as desired for a particular application. The 2D-grating can be selected to reduce the distance between the working point and the measuring point, which reduces the error in determining the working point. **FIG. 2** discussed above illustrates the 2D-grating disposed on the second side **62** of the planar motor **58.** Those skilled in the art will appreciate that the various locations of the 2D-grating with associated planar motor apertures and transparent portions as illustrated in **FIGS. 2****,** **10A, & 10B** can be used for displacement devices employing a single optical sensor or a number of optical sensors.

Referring to **FIG. 10A****,** the planar motor **58** defines a motor aperture **150** and the 2D-grating **68** is disposed over the motor aperture **150** at the first side **60** of the planar motor **58.** The 2D-grating **68** can be attached to the first side **60** or can be located within the motor aperture **150** as desired for a particular application. In one embodiment, the 2D-grating **68** is a transparent body, such as a body made of polycarbonate, with the grating pattern printed on one side of the 2D-grating **68** adjacent the workpiece **40** and away from the first side **60** of the planar motor **58.**

Referring to **FIG. 10B****,** the planar motor **58** has a transparent portion **152** and the 2D-grating **68** is disposed on the first side **60** of the planar motor **58** on the transparent portion **152.** The sensing beam **74** from the optical sensor **52** passes through the transparent portion **152** on the way to and from the measuring point **72.** In one embodiment, the 2D-grating **68** is attached to the transparent portion **152** at the first side **60.** In another embodiment, the 2D-grating **68** is formed as part of the transparent portion **152** at the first side **60,** such as formation by printing on the transparent portion **152** of the planar motor **58,** so that the print is next to the workpiece **40.** Such grating patterns can be printed using holography, interferometry, lithography, or the like. In one embodiment, the transparent portion **152** extends across the whole width of the planar motor **58;** i.e., the planar motor **58** is transparent.

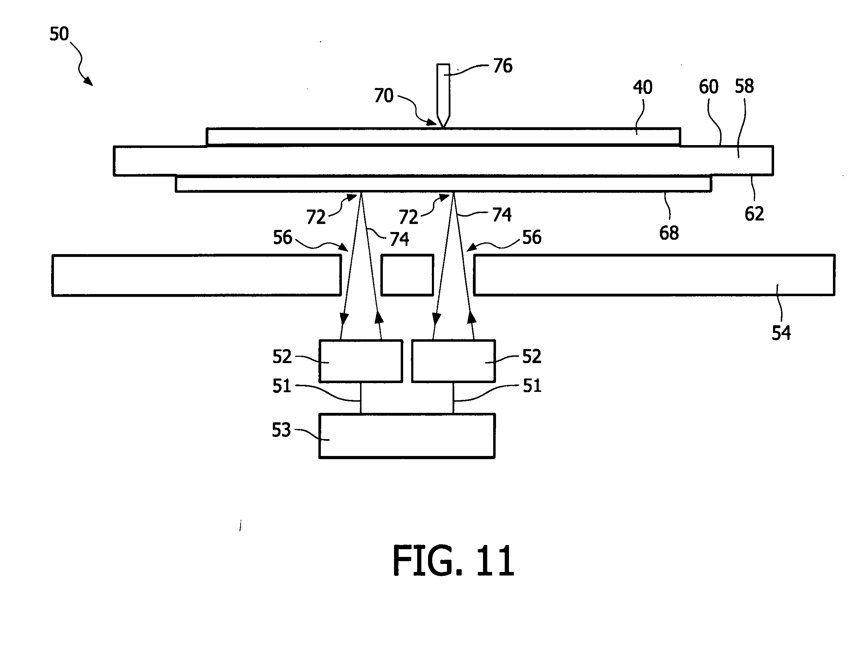

**FIG. 11****,** in which like elements share like reference numbers with **FIG. 2****,** is a schematic diagram of another embodiment of a displacement device made in accordance with the present invention. In this embodiment, more than one optical sensor is used to provide additional precision. Additional optical sensors are particularly useful when the thickness of the planar motor is large to counteract the Abbé effect, i.e. the error resulting from pitch and yaw of the planar motor. When the measuring point **72** is directly across the planar motor **58** from a point sized working point **70** on the workpiece **40,** the Abbé error resulting from the Abbé effect depends primarily on the distance between the measuring point **72** and the working point **70,** i.e., the combined thickness of the 2D-grating **68,** planar motor **58,** and workpiece **40.**

The displacement device **50** includes two optical sensors **52** determining the displacement of the planar motor **58** by detecting the motion of the 2D-grating **68** disposed on the planar motor **58.** In this example, one optical sensor **52** is located across the planar motor **58** from a working point **70** on the workpiece **40** and the other optical sensor **52** is located across the planar motor **58** away from the working point **70.** As defined herein, a component or point is located across the planar motor **58** away from the working point **70** when a line normal to the first side **60** of the planar motor **58** intersecting the working point **70** does not intersect the component or point. In another embodiment, both the optical sensors **52** are located across the planar motor **58** away from the working point **70.** Those skilled in the art will appreciate that the locations of the optical sensors **52** can be selected as desired for a particular application, considering factors such as precision required, geometry of the displacement device components, components internal to the support plate that could interfere with placement of the support plate apertures, and the like.

The embodiment illustrated in **FIG. 11** includes two optical sensors **52.** The number of optical sensors **52** is selected at a minimum as a determinative measurement number, which is defined herein as the number of optical sensors required to determine position of a plane having six degrees of freedom. The determinative measurement number varies depending on the degrees of freedom of the particular optical sensors employed. In one embodiment, the determinative measurement number is one when the optical sensor **52** is a six-degree-of-freedom optical sensor making three translation measurements and three rotation measurements. In another embodiment, the determinative measurement number is three when the optical sensors 52 are two-degree-of-freedom optical sensors with each measuring two independent translations. For example, one optical sensor can measure X and Y translations, another optical sensor can measure Y and Z translations, and yet another optical sensor can measure X and Z translations. In yet another embodiment, the degrees-of-freedom can be different for the different optical sensors. For example, one optical sensor can be a three-degree-of-freedom optical sensor measuring X, Y, and Z translations, another optical sensor can be a two-degree-of freedom optical sensor measuring X and Y translations, and yet another optical sensor can be a one-degree-of-freedom optical sensor measuring Z translations. Those skilled in the art will appreciate that the determinative measurement number for translation optical sensors is any number of optical sensors providing six independent translation measurements.

The number of optical sensors **52** can also be selected as greater than the determinative measurement number. For example, one six-degree-of-freedom optical sensor can be used with another optical sensor, such as a six-degree-of-freedom optical sensor, three-degree-of-freedom optical sensor, or one-degree-of-freedom optical sensor, to provide redundant position measurement. Because the measurements exceed the degrees of freedom of the planar motor, i.e., the position information is overdetermined, the measurements are converted into a calculated position. In one embodiment, the overdetermined measurements in a particular direction, such as the X translations, are averaged. In another embodiment, the overdetermined measurements are position weighted, such as weighting each measurement by the distance between the measuring point and the working point. The processor **53** receiving position information signals **51** from the optical sensors **52** can perform the conversion into a calculated position.

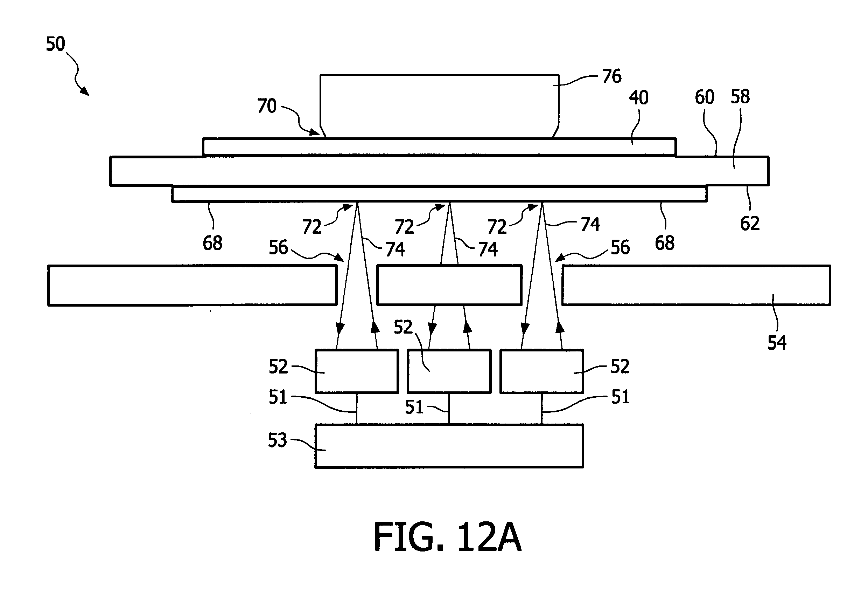

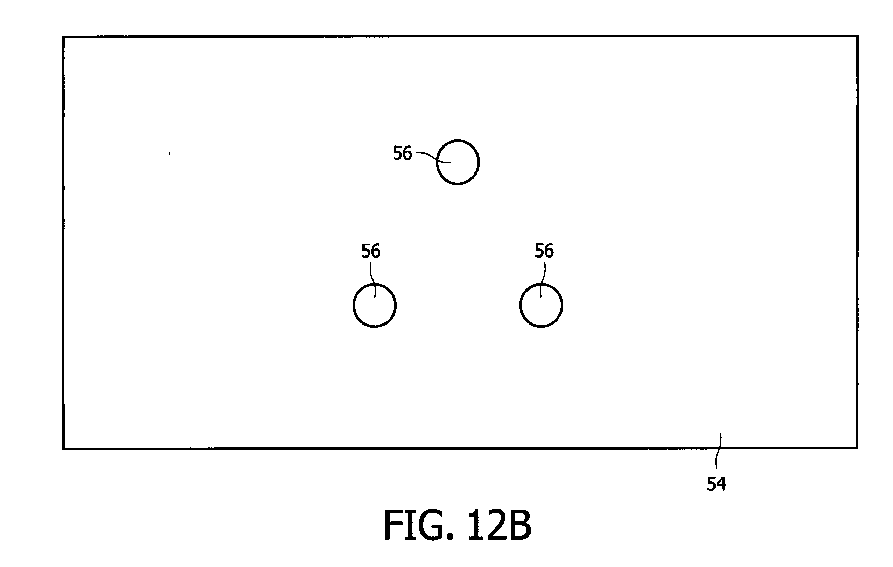

**FIGS. 12A-12B****,** in which like elements share like reference numbers with **FIG. 2****,** are schematic diagrams of yet another embodiment of a displacement device made in accordance with the present invention. **FIG. 12A** is a side view of the displacement device **50** and **FIG. 12B** is a top view of the support plate **54** illustrating the support plate apertures **56.** In this example, the working beam **76** spreads over the workpiece **40** so that the working point **70** is a broad plane over the surface of the workpiece **40.** Additional optical sensors are particularly useful when the thickness of the planar motor and/or the broad plane of the working point **70** is large to counteract the Abbe effect, i.e. the error resulting from pitch and yaw of the planar motor. When the working point **70** on the workpiece **40** is a plane rather than a point, the Abbé error in locating a particular point in the plane of the working point **70** depends both on the distance between the particular point and the measuring point **72,** i.e., the combined thickness of the 2D-grating **68,** planar motor **58,** and workpiece **40,** and the distance in the plane of the working point **70** between the particular point and the measuring point **72.**

The optical sensors **52** can be any suitable optical sensors having the desired number of degrees of freedom for the particular application. As defined herein, the degree of freedom of an optical sensor is the independent number of translations and/or rotations the optical sensor can measure. In one embodiment, the optical sensors are six-degree-of freedom, three-degree-of-freedom, two-degree-of-freedom, one-degree-of-freedom optical sensors, or a combination thereof. An exemplary six-degree-of-freedom is described in **FIGS. 7-9** and associated text. The optical sensors can be position sensitive detectors, which are defined herein as optical sensors that can measure one or more directions of translation. Exemplary position sensitive detectors are the NanoGrid Planar Encoder System available from OPTRA, Inc., of Topsfield, Massachusetts, USA, and the PP 281 R Two-Coordinate Incremental Encoder available from Dr. Johannes Heidenhain GmbH, Traunreut, Germany.

In the embodiment **of** **FIGS. 12A-12B****,** three or more optical sensors are used to provide additional precision. The number of optical sensors is at least the determinative measurement number, which is defined herein as the number of optical sensors required to determine position of a plane having six degrees of freedom. Three two-degree-of freedom optical sensors arranged in a triangular, non-linear pattern with 10 centimeter separation between the three measuring points can achieve a measurement repeatability of 0.1 nanometer for translation and 1 nanorad for rotation. Those skilled in the art will appreciate that the accuracy is also dependent on the quality of the 2D-grating. The number of optical sensors **52** can also be selected as greater than the determinative measurement number so that the position information is overdetermined. A processor receiving position information signals from the optical sensors can perform a conversion into a calculated position.

The displacement device **50** includes three optical sensors **52** determining the displacement of the planar motor **58** by detecting the motion of the 2D-grating **68** disposed on the planar motor **58.** In this example, the three optical sensors **52** are located across the planar motor **58** away from the working point **70** on the workpiece **40,** although one of the optical sensors **52** can be located across the planar motor **58** from a working point **70** if desired. Those skilled in the art will appreciate that the locations of the optical sensors **52** can be selected as desired for a particular application, considering factors such as precision required, geometry of the displacement device components, components internal to the support plate that could interfere with placement of the support plate apertures, and the like.

Three-degree-of-freedom optical sensors can be used to measure translation and rotation since the optical sensors **52** are arranged in a triangular, non-linear pattern. For most applications, it is sufficient to separate the sensors at a distance comparable to the field of view of the system, i.e., the broad plane of the working point **70** over the surface of the workpiece **40.** For example, in lithography, the field of view (also called dye size) is often 26 x 32 millimeters. In that case, a typical separation distance thus would be 30 millimeters. Six-degree-of-freedom optical sensors or a mixture of various degree-of-freedom optical sensors can also be used. Additional optical sensors can be added as desired for a particular application. When the working point **70** is a sharp point rather than a broad plane, the measuring points **72** can be near the working point **70** or can be at the edges of the workpiece **40** as desired.

While the embodiments of the invention disclosed herein are presently considered to be preferred, various changes and modifications can be made without departing from the scope of the invention. The scope of the invention is indicated in the appended claims, and all changes that come within the meaning and range of equivalents are intended to be embraced therein.

## Claims

1. A displacement device for supporting a workpiece comprising:
an optical sensor **(52);**
a support plate **(54);** and
a planar motor **(58)** disposed parallel the support plate **(54),** the planar motor **(58)** having a first side **(60)** operable to support the workpiece **(40)** and a second side **(62)** opposite the support plate **(54);**
**characterized in that**
the support plate **(54)** defines a support plate aperture **(56)** and
a 2D-grating **(68)** is disposed on the planar motor **(58),** the 2D-grating **(68)** being in optical communication with the optical sensor **(52)** through the support plate aperture **(56).**

2. The device of claim 1 wherein the optical sensor **(52)** in operation is located across the planar motor **(58)** from a working point **(70)** on the workpiece **(40).**

3. The device of claim 1 wherein the optical sensor **(52)** is a six-degree-of-freedom optical sensor operable to measure a displacement of the workpiece in six degrees of freedom.

4. The device of claim 1 wherein the 2D-grating **(68)** is a transparent body with a grating pattern printed on a side of the transparent body, the printed side being away from the first side **(60)** of the planar motor **(58).**

5. The device of claim 1 further comprising a grating disposed adjacent the 2D-grating **(68)** to form a 3D-grating.

6. The device of claim 1 comprising
a plurality of optical sensors **(52);**
wherein the support plate **(54)** defines a plurality of support plate apertures **(56);** wherein the 2D-grating **(68)** is in optical communication with the plurality of optical sensors **(52)** through the plurality of support plate apertures **(56);** and
wherein the number of the plurality of optical sensors **(52)** is at least a determinative measurement number.

7. The device of claim 6 wherein the number of the plurality of optical sensors **(52)** is greater than the determinative measurement number, further comprising a processor **(53)** receiving a plurality of position information signals **(51)** from the plurality of optical sensors **(52)** and being operable to convert the plurality of position information signals **(51)** to a calculated position of the planar motor **(58).**

8. The device of claim 7 wherein the processor **(53)** is operable to convert the plurality of position information signals **(51)** to the calculated position by a method selected from the group consisting of averaging and position weighting.

9. The device of claim 1 or 6 wherein the 2D-grating **(68)** is disposed on the second side **(62)** of the planar motor **(58).**

10. The device of claim 1 or 6 wherein the planar motor **(58)** defines a motor aperture **(150)** and the 2D-grating **(68)** is disposed over the motor aperture **(150)** at the first side **(60)** of the planar motor **(58).**

11. The device of claim 1 or 6 wherein the planar motor **(58)** has a transparent portion **(152)** and the 2D-grating **(68)** is disposed on the first side **(60)** of the planar motor **(58)** on the transparent portion **(152).**

## Patentansprüche

1. Verschiebevorrichtung zum Tragen eines Werkstücks mit:
einem optischen Sensor (52);
einer Trägerplatte (54); sowie
einem Flächenmotor (58), der parallel zu der Trägerplatte (54) angeordnet ist, wobei der Flächenmotor (58) eine erste Seite (60), die so wirkt, dass sie das Werkstück (40) trägt, und eine zweite Seite (62) gegenüber der Trägerplatte (54) aufweist;
**dadurch gekennzeichnet, dass**
die Trägerplatte (54) eine Trägerplattenöffnung (56) definiert und
ein 2D-Gitter (68) auf dem Flächenmotor (58) angeordnet ist, wobei sich das 2D-Gitter (68) durch die Trägerplattenöffnung (56) in optischer Kommunikation mit dem optischen Sensor (52) befindet.

2. Vorrichtung nach Anspruch 1, wobei sich der optische Sensor (52) von einem Arbeitspunkt (70) auf dem Werkstück (40) aus bei Betrieb über dem Flächenmotor (58) befindet.

3. Vorrichtung nach Anspruch 1, wobei der optische Sensor (52) ein optischer Sensor mit sechs Freiheitsgraden ist, der so wirkt, dass er eine Verschiebung des Werkstücks in sechs Freiheitsgraden misst.

4. Vorrichtung nach Anspruch 1, wobei das 2D-Gitter (68) ein transparenter Körper mit einer auf einer Seite des transparenten Körpers aufgedruckten Gitterstruktur ist, wobei die bedruckte Seite von der ersten Seite (60) des Flächenmotors (58) entfernt ist.

5. Vorrichtung nach Anspruch 1, die weiterhin ein Gitter umfasst, das sich zur Ausbildung eines 3D-Gitters in Angrenzung an das 2D-Gitter (68) befindet.

6. Vorrichtung nach Anspruch 1, mit:
mehreren optischen Sensoren (52);
wobei die Trägerplatte (54) mehrere Trägerplattenöffnungen (56) definiert;
wobei sich das 2D-Gitter (68) durch die mehreren Trägerplattenöffnungen (56) in optischer Kommunikation mit den mehreren optischen Sensoren (52) befindet; und
wobei die Anzahl der mehreren optischen Sensoren (52) zumindest eine maßgebliche Messzahl ist.

7. Vorrichtung nach Anspruch 6, wobei die Anzahl der mehreren optischen Sensoren (52) größer als die maßgebliche Messzahl ist, wobei die Vorrichtung weiterhin einen Prozessor (53) umfasst, der mehrere Positionsinformationssignale (51) von dem mehreren optischen Sensoren (52) empfängt und so wirkt, dass er die mehreren Positionsinformationssignale (51) in eine errechnete Position des Flächenmotors (58) konvertiert.

8. Vorrichtung nach Anspruch 7, wobei der Prozessor (53) so wirkt, dass er die mehreren Positionsinformationssignale (51) unter Anwendung eines Verfahrens, ausgewählt aus der Gruppe umfassend Mittelwertbildung und Positionsgewichtung, in die errechnete Position konvertiert.

9. Vorrichtung nach Anspruch 1 oder 6, wobei sich das 2D-Gitter (68) auf der zweiten Seite (62) des Flächenmotors (58) befindet.

10. Vorrichtung nach Anspruch 1 oder 6, wobei der Flächenmotor (58) eine Motoröffnung (150) definiert und das 2D-Gitter (68) sich über der Motoröffnung (150) auf der ersten Seite (60) des Flächenmotors (58) befindet.

11. Vorrichtung nach Anspruch 1 oder 6, wobei der Flächenmotor (58) einen transparenten Teil (152) aufweist und sich das 2D-Gitter (68) auf der ersten Seite (60) des Flächenmotors (58) auf dem transparenten Teil (152) befindet.

## Revendications

1. Dispositif de déplacement conçu pour supporter une pièce de fabrication comprenant :
un capteur optique (52) ;
une plaque support (54) ; et
un moteur planaire (58) disposé parallèlement à la plaque support (54), le moteur planaire (58) présentant un premier côté (60) apte à supporter la pièce de fabrication (40) et un second côté (62) face à la plaque support (54) ;
**caractérisé en ce que**
la plaque support (54) définit une ouverture de plaque support (56) et
un réseau 2D (68) est disposé sur le moteur planaire (58), le réseau 2D (68) étant en communication optique avec le capteur optique (52) à travers l'ouverture de plaque support (56).

2. Dispositif selon la revendication 1, dans lequel le capteur optique (52) en fonctionnement est situé à travers le moteur planaire (58) à partir d'un point de travail (70) sur la pièce de fabrication (40).

3. Dispositif selon la revendication 1, dans lequel le capteur optique (52) est un capteur optique à six degrés de liberté apte à mesurer un déplacement de la pièce de fabrication dans six degrés de liberté.

4. Dispositif selon la revendication 1, dans lequel le réseau 2D (68) est un corps transparent avec un motif de réseau imprimé sur un côté du corps transparent, le côté imprimé étant éloigné du premier côté (60) du moteur planaire (58).

5. Dispositif selon la revendication 1, comprenant en outre un réseau disposé adjacent au réseau 2D (68) pour former un réseau 3D.

6. Dispositif selon la revendication 1 comprenant
une pluralité de capteurs optiques (52) ;
dans lequel la plaque support (54) définit une pluralité d'ouvertures de plaque support (56) ;
dans lequel le réseau 2D (68) est en communication optique avec la pluralité de capteurs optiques (52) à travers la pluralité d'ouvertures de plaque support (56) ; et
dans lequel le nombre de la pluralité de capteurs optiques (52) est au moins un nombre de mesure déterminative.

7. Dispositif selon la revendication 6, dans lequel le nombre de la pluralité de capteurs optiques (52) est supérieur au nombre de mesure déterminative, comprenant en outre un processeur (53) recevant une pluralité de signaux d'informations de position (51) de la pluralité de capteurs optiques (52) et apte à convertir la pluralité de signaux d'informations de position (51) en une position calculée du moteur planaire (58).

8. Dispositif selon la revendication 7, dans lequel le processeur (53) est apte à convertir la pluralité de signaux d'informations de position (51) en la position calculée par un procédé sélectionné dans le groupe se composant du calcul de moyenne et de la pondération de position.

9. Dispositif selon la revendication 1 ou 6, dans lequel le réseau 2D (68) est disposé sur le second côté (62) du moteur planaire (58).

10. Dispositif selon la revendication 1 ou 6, dans lequel le moteur planaire (58) définit une ouverture de moteur (150) et le réseau 2D (68) est disposé sur l'ouverture de moteur (150) sur le premier côté (60) du moteur planaire (58).

11. Dispositif selon la revendication 1 ou 6, dans lequel le moteur planaire (58) comporte une partie transparente (152) et le réseau 2D (68) est disposé sur le premier côté (60) du moteur planaire (58) sur la partie transparente (152).
